(19) **Europäisches Patentamt**

**European Patent Office**

**Office européen des brevets**

(11) **EP 1 439 457 A1**

(12) **DEMANDE DE BREVET EUROPEEN**

(43) Date de publication:
**21.07.2004 Bulletin 2004/30**

(51) Int Cl.⁷: **G06F 7/58**
// **H03M7/40**

(21) Numéro de dépôt: **03104395.3**

(22) Date de dépôt: **26.11.2003**

(84) Etats contractants désignés:
**AT BE BG CH CY CZ DE DK EE ES FI FR GB GR
HU IE IT LI LU MC NL PT RO SE SI SK TR**
Etats d'extension désignés:
**AL LT LV MK**

(30) Priorité: **29.11.2002 FR 0215063**

(71) Demandeur: **Thales
92200 Neuilly Sur Seine (FR)**

(72) Inventeur: **Remi, Frédéric, c/o THALES,
Intellectual Property
94117 CX Arcueil (FR)**

(74) Mandataire: **Dudouit, Isabelle
THALES Intellectual Property,
31-33 avenue Aristide Briand
94117 Arcueil Cedex (FR)**

(54) **Générateur d'aléa numérique reposant sur un compresseur arithmétique**

(57)    Le dispositif proposé permet de construire un générateur d'aléa parfait en combinant une source physique quelconque, sur laquelle on ne fait pas d'hypothèses de qualité, et un extracteur. L'extracteur est constitué d'un codeur arithmétique et d'une fonction linéaire de sortie permettant de lisser les biais résiduels de sortie.

FIG.2

**Description**

L'invention concerne un Générateur d'Alea numérique reposant notamment sur un compresseur arithmétique.

Elle s'applique par exemple dans les dispositifs du domaine industriel utilisant de l'alea pur. On peut l'utiliser dans les jeux de hasard sur Internet, dans le système de tirage RAPIDO de la Française des jeux ou encore dans des calculs d'Astronomie.

Elle peut aussi être utilisée dans le domaine de la cryptologie, la sécurité des algorithmes de chiffrement et de nombreux protocoles cryptographiques reposant sur l'existence de paramètres totalement aléatoires (clés de chiffrement, challenge,...).

L'invention trouve aussi son application dans les procédures sécurisées en ligne (achat, télé-procédure, authentification de documents, etc.) reposant sur l'utilisation de la signature électronique qui accentue les besoins en aléa pur « temps réel ». Un serveur de commerce électronique doit en effet être capable d'effectuer plusieurs centaines de signatures électroniques par seconde.

La génération d'aléa numérique à l'aide d'un dispositif électronique consiste à échantillonner plus ou moins directement une grandeur instable et non reproductible. Cette grandeur peut être l'amplitude d'un signal analogique, la durée entre deux événements, etc..

L'aspect aléatoire de l'information obtenue est alors liée aux caractéristiques du signal d'origine et/ou à l'imprécision de la mesure. Dans la pratique actuelle, les industriels utilisent différentes méthodes pour générer de l'Aléa, par exemple, l'amplification analogique d'un signal bruité, l'échantillonnage d'une horloge A avec une horloge B asynchrone.

L'aléa généré par ces diverses sources physiques présente généralement des défauts statistiques caractéristiques, tels que des défauts d'équidistribution, l'existence de pseudo périodes, etc.. Ces défauts ont pour conséquence que l'entropie réelle de l'aléa produit est inférieure à son entropie maximale théorique (l'entropie de SHANNON mesure l'information moyenne apportée par une variable aléatoire).

Plusieurs solutions plus ou moins complexes et plus ou moins coûteuses existent alors pour éliminer ces biais caractéristiques, par exemple :

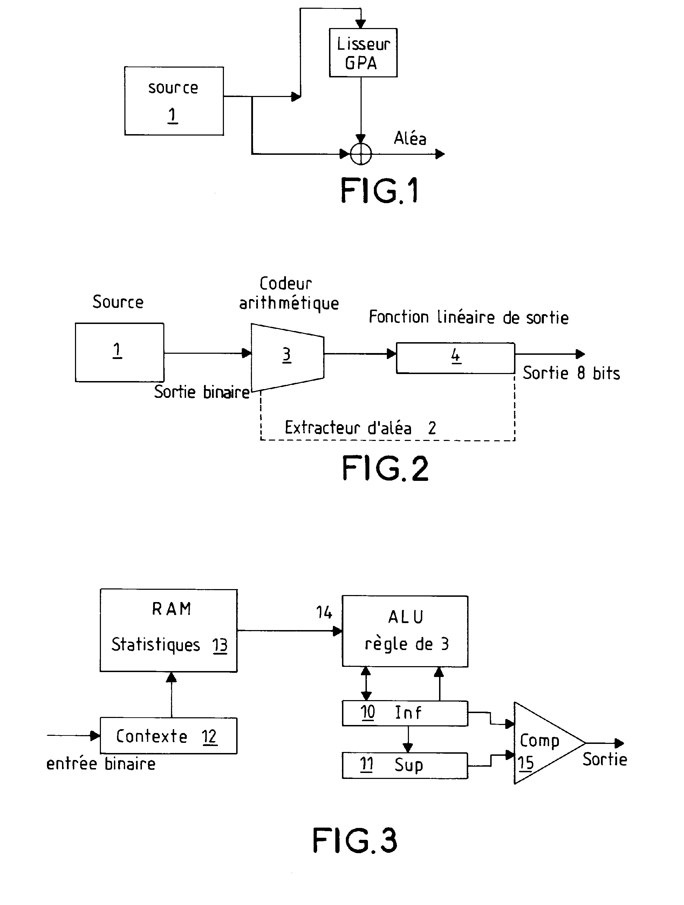

- L'ajout en aval d'un dispositif cryptographique de lissage permettant de produire une suite d'aléa parfaite à partir d'une suite de débit plus élevée présentant des défauts entropiques. Le lisseur utilisé est dans la pratique un Générateur de Pseudo Aléa (GPA) pouvant être implémenté soit en matériel, soit en logiciel en fonction des contraintes souhaitées de sécurité et de débit. La figure 1 représente le schéma d'un tel dispositif,
- L'utilisation de plusieurs sources physiques en parallèle pour lisser les défauts.

Par ailleurs, la complexité de ces différentes architectures (implémentation du GDA dans deux FPGA) fournissent des méthodes de génération d'aléa qui ne sont pas adaptées, en terme de débit, aux besoins «temps réel » en aléa parfait.

La demande de brevet EP 1 223 506 décrit un générateur d'aléa qui met en oeuvre une méthode de compression à base de dictionnaire. Cette méthode est bien adaptée à la compression de sources à forte redondance mais ne convient pas pour la compression de suites binaires provenant de l'échantillonnage d'une source physique.

L'idée sur laquelle reposent le procédé et le dispositif selon l'invention utilise notamment le concept d'extracteur d'Aléa. Un extracteur d'aléa est un dispositif déterministe qui est destiné à être inséré à la suite d'une source d'aléa physique pour en supprimer les défauts.

L'invention concerne un générateur de nombres aléatoires adapté à recevoir en entrée un nombre de bits provenant d'une source physique. Il est caractérisé en ce qu'il comporte en combinaison au moins une source physique générant des symboles, un codeur arithmétique et des moyens adaptés à lisser les biais résiduels en sortie du codeur. L'association du codeur arithmétique et de la fonction linéaire est appelé extracteur d'aléa et constitue le dispositif déterministe du générateur d'aléa.

L'invention concerne aussi un procédé permettant de générer des nombres aléatoires comportant en combinaison au moins les étapes suivantes :

- Recevoir plusieurs symboles d'une source physique,
- Transmettre les symboles à une étape de codeur arithmétique,
- Lisser les symboles codés en utilisant une fonction linéaire.

L'invention présente notamment les avantages suivants :

- Une facilité d'implémentation aussi bien en matériel qu'en logiciel,
- Une possibilité d'offrir des débits en aléa parfait qui correspondent aux besoins des serveurs de commerce électronique (e-commerce),

- Une adaptabilité de l'extracteur par rapport aux caractéristiques de la source physique qui sont susceptibles d'évoluer au cours du temps,
- La possibilité d'implémenter une source physique rudimentaire pouvant éventuellement générer des suites binaires ayant de faibles caractéristiques aléatoires (fort biais à l'équidistribution, dépendances entre les bits générés : caractère markovien).

D'autres caractéristiques et avantages de l'invention apparaîtront mieux à la lecture de la description qui suit d'un exemple donné à titre illustratif et nullement limitatif annexé des figures qui représentent :

- La figure 1 un synoptique de Générateur d'Aléa implémenté selon l'état de l'art antérieur,
- La figure 2 un schéma bloc fonctionnel d'un exemple d'architecture d'un générateur aléatoire selon l'invention,
- La figure 3 un diagramme du codeur arithmétique,
- La figure 4 un synoptique de la fonction linéaire de sortie.

La figure 2 fournit un schéma synoptique d'un exemple d'architecture de Générateur d'Aléa selon l'invention. Il comporte par exemple une source physique quelconque 1 et un extracteur d'aléa 2 disposé juste après. L'extracteur d'aléa 2 se compose d'un codeur arithmétique 3 et d'une fonction linéaire de sortie 4.

Pour une mise en oeuvre simple de la source, on peut par exemple générer un signal numérique oscillant, dont la fréquence est instable en fonction de la température, de la tension d'alimentation et de la dispersion des caractéristiques entre puces électroniques. Il suffit alors d'échantillonner ce signal à l'aide d'une horloge issue du système (horloge du microprocesseur de la carte par exemple). Les deux horloges étant asynchrones et glissantes l'une par rapport à l'autre, le signal résultant est peu prédictible et peu reproductible.

Le codage arithmétique est un codage statistique dynamique qui s'adapte aux caractéristiques de la source physique. Le codeur est par exemple paramétré pour traiter les symboles générés par la source physique indépendamment les uns des autres (modèle de Bernoulli) ou bien de façon dépendante (modèle de Markov). Dans l'exemple donné, le modèle choisi est un modèle Markovien qui se révèle particulièrement efficace pour modéliser le type de source physique que nous décrivons dans cette invention.

La loi de probabilité utilisée par le compresseur est par exemple ajustée en permanence en fonction des symboles réellement apparus.

Un des intérêts de l'invention est que le codeur arithmétique est très simple à implémenter en matériel. Le GDA (Générateur d'Aléa) constitué par la source physique, le codeur et la fonction linéaire de sortie est par exemple implémentable dans un composant programmable de type FPGA. Les étapes du procédé sont réalisées dans un calculateur programmé pour exécuter certaines taches algorithmiques.

En conséquence, la loi de probabilité utilisée par le compresseur est ajustée en permanence en fonction des symboles réellement apparus.

Le principe du codage arithmétique est de coder un message par un nombre représenté par exemple en numération binaire et en virgule flottante. Ce nombre est issu de calculs d'intervalles emboîtés. Chaque intervalle correspond à un symbole de la source et sa taille est proportionnelle à sa fréquence d'occurrence. La compression est obtenue en notant que le nombre de chiffres significatifs nécessaires pour décider de l'appartenance à un intervalle est plus faible que pour les gros intervalles.

Chaque symbole s est par exemple représenté par un intervalle [$m_s$, $M_s$] de telle sorte que :

  ➢ La taille de l'intervalle $\Delta = M_s - m_s$ est proportionnelle à la probabilité d'apparition du symbole $s$ ;

  ➢ Les intervalles sont disjoints ;

  ➢ La réunion des intervalles est égale à l'intervalle [0,1]

L'algorithme de codage est alors le suivant :

  1. initialiser $m \rightarrow 0$ et $M \rightarrow 1$

  2. mettre à jour pour chaque symbole s du message à comprimer :

  a. $\Delta \leftarrow M - m$ ;

$$\text{b. } m \leftarrow m + \Delta \times m_s \text{ ;}$$

$$\text{c. } M \leftarrow m + \Delta \times M_s$$

3. le message comprimé est la dernière valeur de m.

L'exemple chiffré donné ci-après illustre de manière simpliste le codage arithmétique en virgule flottante.

La source physique utilisée est S={a,b,c}. Les fréquences d'occurrence des trois symboles sont donnés dans le tableau 1 ci dessous :

| Symbole | Fréquence | $[m_s, M_S]$ |
|---------|-----------|--------------|
| a | 1/2 | (0.0, 0.5) |
| b | 1/4 | (0.5, 0.75) |
| c | 1/4 | (0.75, 1.0) |

Le tableau 2 ci après décrit les étapes du codage de la chaîne de caractère « *baca* ». Le message comprimé est la dernière valeur de *m*

| Symboles à coder | Taille de l'intervalle | m | M |
|------------------|------------------------|---|---|
| | | 0 | 1 |
| b | 1 | 0.5 | 0.75 |
| a | 0.25 | 0.5 | 0.625 |
| c | 0.125 | 0.59375 | 0.625 |
| a | 0.03125 | **0.59375** | 0.609375 |

La figure 3 schématise un exemple d'architecture d'un codeur arithmétique.

Le codeur comporte par exemple une table des statistiques ou RAM 13, recevant des informations de contexte 12. Les informations de contexte sont délivrées par la source physique sous la forme d'un caractère courant. Des registres de 16 bits (référencés 10 et 11) mémorisent les valeurs inférieure et supérieure de l'intervalle précité. Une unité logique (ALU) 14 est programmée pour effectuer une mise à jour des valeurs des bornes des intervalles Inf et Sup en fonction des nouvelles tables statistiques stockées en RAM 13.

Un comparateur 15 effectue une comparaison des registres Inf et Sup et délivre les bits de poids forts que ces registres ont en commun.

Le compressé de la source est un intervalle qui est décrit, à chaque instant par les deux registres 10, 11 qui contiennent respectivement la borne inférieure et la borne supérieure. Seuls les 16 derniers bits significatifs de l'intervalle courant sont mémorisés, c'est-à-dire, ceux à partir desquels les chiffres sont distincts.

Les étapes de codage d'un symbole consistent par exemple à :

- Mettre à jour la table des statistiques 13 sur les symboles d'entrée en fonction des contextes 12, i.e, les symboles précédents,
- Calculer par une règle de trois, au moyen d'une ALU 14, les nouvelles valeurs des bornes de l'intervalle,
- Vider les registres des bits de poids fort qu'ils ont en commun. Ces bits constituent la sortie du comparateur 15.

Dans la pratique, on utilise par exemple l'arithmétique entière et non pas réelle. Les registres ayant des tailles plus réduites que le message à comprimer, on vide au fur et à mesure que les nouveaux symboles à coder arrivent les registres contenant les valeurs de m et de M des bits de poids fort qu'ils ont en commun.

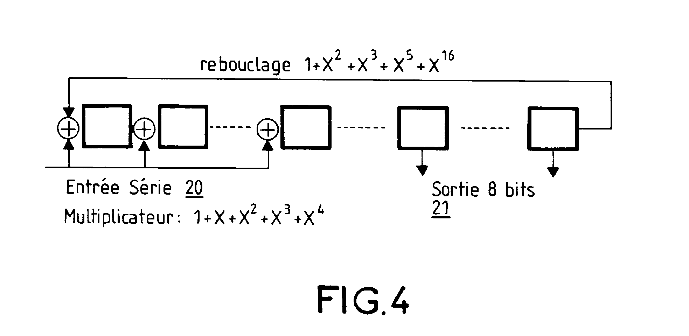

La figure 4 schématise un exemple de moyens permettant de mettre en oeuvre la fonction linéaire de sortie. Cette dernière a notamment pour but de lisser les biais résiduels qui peuvent subsister en sortie de la fonction de compression. Elle a été conçue pour que, si les entrées ont un biais résiduel majoré par une quantité $\varepsilon$, alors les composantes de l'octet de sortie auront un biais résiduel majoré par $\varepsilon^8$ (d'où la propriété de lissage).

La fonction linéaire est formée en matériel par exemple par un registre de 16 bits, c'est à dire 16 bascules élémentaires D. En soft (en langage C), on le déclare comme un mot de type unsigned short.

La fonction linéaire de sortie comporte par exemple une entrée série 20 et une sortie parallèle 21 sur un nombre de bits donné, par exemple 8 bits. Elle produit un octet d'aléa pour 16 avances de l'horloge et 16 symboles binaires aléatoires extraits du codeur arithmétique. Elle comprend par exemple une mémoire interne de 16 bits.

Lorsqu'on représente l'état interne par un polynôme de degré au plus 15, la fonction de transition de cet automate est :

$$U_{t+1} \leftarrow (XU_t + e_t A) \bmod P$$

où :

> $U_t$ représente l'état interne de l'automate à l'instant t ;

> A est une constante multiplicative polynomiale égale à : $1 + X + X^2 + X^3 + X^4$

> P est le polynôme de rebouclage égal à : $1 + X^2 + X^3 + X^5 + X^{16}$

> $e_t$ est l'entrée binaire à l'instant t.

L'automate est par exemple une fonction mathématique déterministe qui possède un état interne évoluant au court du temps en fonction d'une fonction de transition.

L'exemple chiffré donné ci-après permet de mieux illustrer le principe de fonctionnement de l'invention.

**Choix des paramètres du compresseur**

Le compresseur (codeur) arithmétique nécessite une mémoire pour stocker les données statistiques de la source. La taille $t$ en nombre de mots de cette mémoire est donnée par :

$$t = 2^{r+1} \times m = 2^{n(r+1)}$$

où:

> $r$ est l'ordre du modèle markovien considéré; les probabilités d'apparition des symboles dépendent des $r$ symboles précédents de la source ;
> $m$ est la taille d'ensemble des symboles si on considère des symboles binaires de $n$ bits, on a $m = 2^n$.

Pour une taille de mémoire donnée, il existe plusieurs combinaisons de paramètres $r$ et $n$ envisageables. Pour une taille de 4 kilos mots, les deux choix extrêmes sont :

> un modèle d'ordre 0 avec des symboles de 12 bits;
> un modèle d'ordre 11 avec des symboles binaires.

Une expérience a été conduite avec différentes valeurs des paramètres $r$ et $n$ sur une source constituée de variables aléatoires de Bernoulli de paramètre $p = 0{,}6$. Pour ce type de source, le taux maximal de compression, obtenue lorsque l'entropie des symboles en sortie du compresseur est maximale, est égal à 2.9.

Les taux de compression observés sont donnés dans le tableau 1. Pour minimiser l'entropie des symboles en sortie du compresseur, il faut chercher à obtenir le taux de compression le plus élevé. Ces résultats montrent qu'il est avantageux de travailler sur des symboles binaires.

La baisse du taux de compression observé lorsqu'on augmente l'ordre résulte du fait qu'il faut plus longtemps pour obtenir des résultats discriminants dans la table des statistiques. De plus, comme la source est d'ordre 0 dans cette expérience, une compression d'ordre 0 suffit pour obtenir les meilleurs résultats.

En conclusion, le choix est celui d'un modèle d'ordre maximal qui opère sur des symboles binaires.

**Performances de l'extracteur**

Pour évaluer les performances de l'extracteur, la fonction de compression a été soumise au test suivant. La fonction de compression opère sur des symboles binaires (n = 1) et un modèle d'ordre *r* = 8. Deux modèles de sources ont été simulés :

> ➢ Une source de Bernoulli de paramètre p;
> ➢ Une source de Markov équidistribuée sur {0,1}$^8$ et dont la transition est contrôlée par un paramètre *p*; Cette source est de la forme :

$$X_n = f(X_{n-1}, ..., X_{n-7}) \oplus X_{n-8} \oplus Y_n$$

où *f* est une fonction équidistribuée quelconque, et $(Y_n)_{n \geq 0}$ est une suite de variables aléatoires indépendantes de même loi de Bernoulli et de paramètre *p*; Les 8 premiers termes sont les composantes d'un vecteur aléatoire $(X_0, ..., X_7)$ de loi uniforme sur {0,1}$^8$.

Les deux sources ci-dessus ont été choisies pour les raisons suivantes :

1. Elles modélisent un grand nombre de sources d'aléa physique :

- cas d'une source où les symboles sont indépendants, mais non équidistribués ;

- cas d'une source où les symboles sont équidistribués, mais non indépendants ;

2. On connaît le taux de compression théoriquement atteignable pour ce type de source; il est égal à :

$$t = 100 \times (1 - H(p))$$

où

- p est le paramètre qui définit le biais de la source ;

- $H(p)$ est la fonction d'entropie binaire égale à $- 2\log_2(p) - (1 - p) \log_2 (1 - p)$

Un plan de tests statistique classique de la source avant et après compression donne les résultats suivants. La taille de la source est de 220 octets et l'évaluation de l'entropie a été effectuée sur fenêtre coulissante jusqu'à l'ordre 12. Les résultats sont consignés dans les tableaux 3 et 4, regroupant le taux de compression observé ainsi que le taux de compression maximal pour le type de source considéré.

L'examen des résultats montre que le taux de compression observé est très proche du taux théorique. Lorsqu'il est soumis à une source de Markov d'ordre inférieur à l'ordre du modèle du compresseur, la sortie de ce dernier est considérée comme constituée de symboles aléatoires équidistribués et indépendants.

Tableau 3:

| compression d'une source de bernoulli p | | | | |
|---|---|---|---|---|
| Paramètre p | Test Statistique avant compression | Taux de compression observé | Test Statistique après compression | Taux de compression Théorique |
| 0,55 | **KO** | **0,5%** | **0K** | **0,7%** |
| 0,6 | **KO** | **2,65%** | **0K** | **2,9%** |
| 0,7 | **KO** | **11,65%** | **0K** | **11,87%** |
| 0,8 | **KO** | **27,65%** | **0K** | **27,8%** |

Tableau 4:

| compression d'une source de Markov équidistribuée d'ordre 8 de paramètre. | | | | |
|---|---|---|---|---|
| Paramètre p | Test Statistique avant compression | Taux de compression observé | Test Statistique après compression | Taux de compression Théorique |
| 0,55 | **KO** | **0,697%** | **0K** | **0,7%** |
| 0,6 | **KO** | **2,878%** | **0K** | **2,9%** |
| 0,7 | **KO** | **11,834%** | **0K** | **11,87%** |
| 0,8 | **KO** | **27,778%** | **0K** | **27,8%** |

**Revendications**

1. Générateur d'aléa adapté à recevoir en entrée un nombre de bits provenant d'une source physique quelconque **caractérisé en ce qu'**il comporte en combinaison au moins une source physique générant des symboles, un codeur arithmétique dynamique et des moyens adaptés à lisser les biais résiduels de sortie.

2. Générateur selon la revendication 1 **caractérisé en ce que** les moyens adaptés à lisser les biais résiduels de sortie sont constitués d'une fonction linéaire de sortie permettant de lisser les biais résiduels de sortie.

3. Générateur selon la revendication 1 **caractérisé en ce que** le codeur arithmétique suit une loi de probabilité ajustable en fonction des symboles reçus.

4. Générateur selon l'une des revendications 1 et 2 **caractérisé en ce que** le codeur arithmétique comporte au moins une table des statistiques sur les symboles d'entrée recevant une information des contextes, plusieurs registres, un comparateur et une unité logique.

5. Générateur selon l'une des revendications 1 et 2 **caractérisé en ce que** les moyens adaptés à lisser les biais comportent un registre, une entrée série et une sortie parallèle.

6. Procédé pour générer des nombres aléatoires comportant en combinaison au moins les étapes suivantes :

   • recevoir plusieurs symboles d'une source physique,

   • transmettre les symboles à une étape de codage arithmétique dynamique,

   • lisser les symboles codés en utilisant une fonction linéaire.

7. Procédé selon la revendication 6 **caractérisé en ce que** l'étape de codage arithmétique est un codage statistique dynamique s'adaptant aux caractéristiques de la source physique.

8. Procédé selon la revendication 6 **caractérisé en ce que** l'étape de codage est une étape de compression arithmétique et **en ce que** la loi de probabilité utilisée est ajustée en permanence en fonction des symboles.

9. Procédé selon la revendication 6 **caractérisé en ce que** l'étape de codage consiste à coder les symboles par un nombre issu de calculs d'intervalles emboîtés, un intervalle [ms, Ms] correspondant à un symbole s et ayant une taille proportionnelle à sa fréquence d'occurrence.

10. Procédé selon la revendication 9 **caractérisé en ce qu'**il comporte au moins les étapes suivantes :

   • Mettre à jour une table des statistiques (13) sur les symboles d'entrée en fonction des contextes (12), i.e, les symboles précédents,

   • Calculer par une règle de trois, les nouvelles valeurs des bornes de l'intervalle [ms, Ms],

- Vider les registres des bits de poids fort qu'ils ont en commun.

**11.** Procédé selon la revendication 9 **caractérisé en ce que** le codage comprend les étapes suivantes

1. initialiser $m \rightarrow 0$ et $M \rightarrow 1$

2. mettre à jour pour chaque symbole s du message à comprimer :

$$\Delta \leftarrow M - m \ ;$$

$$m \leftarrow m + \Delta \times m_s \ ;$$

$$M \leftarrow m + \Delta \times M_s$$

3. choisir le message comprimé comme étant la dernière valeur de m.

**12.** Procédé selon la revendication 6 **caractérisé en ce que** la fonction de lissage fait appel à un polynôme de degré au plus égal à 15.

FIG.1

FIG.2

FIG.3

rebouclage $1 + X^2 + X^3 + X^5 + X^{16}$

Entrée Série 20

Multiplicateur: $1 + X + X^2 + X^3 + X^4$

Sortie 8 bits
21

# FIG.4

**Office européen des brevets**

**RAPPORT DE RECHERCHE EUROPEENNE**

Numéro de la demande

EP 03 10 4395

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X,D | EP 1 223 506 A (ERICSSON TELEFON AB L M) 17 juillet 2002 (2002-07-17) * abrégé; figure 7 * | 1-12 | G06F7/58 |
| A | US 5 757 923 A (KOOPMAN JR PHILIP J) 26 mai 1998 (1998-05-26) * colonne 9, alinéa 2 * * colonne 7 * | 1,2,5,6, 12 | |
| A | US 5 808 572 A (CHAN DIN-YUEN ET AL) 15 septembre 1998 (1998-09-15) * colonne 2, ligne 46 - ligne 65; figure 1 * | 3,4,7-11 | |

| | | | DOMAINES TECHNIQUES RECHERCHES (Int.Cl.7) |
|---|---|---|---|
| | | | G06F H03M |

Le présent rapport a été établi pour toutes les revendications

| Lieu de la recherche | Date d'achèvement de la recherche | Examinateur |
|---|---|---|
| La Haye | 24 mai 2004 | Verhoof, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 03 10 4395

La présente annexe indique les membres de la famille de brevets relatifs aux documents brevets cités dans le rapport de recherche européenne visé ci–dessus.
Lesdits members sont contenus au fichier informatique de l'Office européen des brevets à la date du
Les renseignements fournis sont donnés à titre indicatif et n'engagent pas la responsabilité de l'Office européen des brevets.

24-05-2004

| Document brevet cité au rapport de recherche | | Date de publication | Membre(s) de la famille de brevet(s) | | Date de publication |
|---|---|---|---|---|---|
| EP 1223506 | A | 17-07-2002 | EP | 1223506 A1 | 17-07-2002 |
| | | | WO | 02056170 A1 | 18-07-2002 |
| | | | US | 2004076293 A1 | 22-04-2004 |
| US 5757923 | A | 26-05-1998 | US | 5696828 A | 09-12-1997 |
| | | | EP | 0852033 A2 | 08-07-1998 |
| | | | JP | 2000505214 T | 25-04-2000 |
| | | | WO | 9711423 A2 | 27-03-1997 |
| US 5808572 | A | 15-09-1998 | AUCUN | | |

EPO FORM P0460

Pour tout renseignement concernant cette annexe : voir Journal Officiel de l'Office européen des brevets, No.12/82